Europäisches Patentamt

European Patent Office

Office européen des brevets

(19)

(11) Veröffentlichungsnummer: **0 360 990 B1**

(12) **EUROPÄISCHE PATENTSCHRIFT**

(45) Veröffentlichungstag der Patentschrift: **26.01.94**

(21) Anmeldenummer: **89112529.6**

(22) Anmeldetag: **08.07.89**

(51) Int. Cl.5: **H03C 1/60**, H04B 1/68, H04H 5/00

(54) **Verfahren zur Erzeugung eines amplitudenmodulierten ISB-Sendesignals sowie Vorrichtung zur Durchführung des Verfahrens.**

(30) Priorität: **15.09.88 CH 3445/88**

(43) Veröffentlichungstag der Anmeldung:
**04.04.90 Patentblatt 90/14**

(45) Bekanntmachung des Hinweises auf die Patenterteilung:
**26.01.94 Patentblatt 94/04**

(84) Benannte Vertragsstaaten:
**CH DE ES FR GB IT LI NL**

(56) Entgegenhaltungen:
**EP-A- 0 193 655**
**US-A- 4 324 952**

CONFERENCE RECORD - THE NATIONAL TE-LESYSTEMS CONFERENCE, Galveston, 7.-10. November 1982, Seiten D3.5.1.-D3.5.5., IEEE, New York, US; S. UDALOV: "Independent sideband modulation/demodulation using digitally implemented Hilbert transforms"

CONFERENCE RECORD - THE NATIONAL TE-LESYSTEMS CONFERENCE, Galveston, 7.-10. November 1982, Seiten D3.4.1-D3.4.5, IEEE, New York, US; J.C. SPRINGETT: "Discrete-time signal-processing theory for optimum SSB and ISB modulation/demodulation"

(73) Patentinhaber: **THOMCAST AG**
**Bahnhofstrasse 34**
**CH-5300 Turgi(CH)**

(72) Erfinder: **Tomljenovic, Nenad**
**Stockackerstrasse 32**
**CH-5415 Nussbaumen(CH)**

EP 0 360 990 B1

## Beschreibung

### Technisches Gebiet

Die vorliegende Erfindung bezieht sich auf das Gebiet der Rundfunk-Sendetechnik. Sie betrifft insbesondere ein Verfahren zur Erzeugung eines amplitudenmodulierten Sendesignals mit einem oberen Seitenband und einem unteren Seitenband, welche Seitenbänder voneinander unabhängig unterschiedliche Informationen in Form von unterschiedlichen NF-Signalen übertragen. Ein solches Verfahren ist z.B. aus dem Buch von G.Kennedy, Electronic Communication Systems, McGraw-Hill 1977, S.142-144, bekannt.

Die Erfindung betrifft weiterhin eine Vorrichtung zur Durchführung des Verfahrens.

### Stand der Technik

In der Rundfunk-Uebertragungstechnik, die mit Amplitudenmodulation arbeitet, sind sowohl Verfahren bekannt, bei denen von den zwei entstehenden Seitenbändern nur eines übertragen wird (SSB = Single Side Band), als auch Verfahren, bei denen mehrere Seitenbänder übertragen werden, die unabhängig voneinander unterschiedliche Informationen enthalten (ISB = Independent Side Band).

Gerade die ISB-Verfahren ermöglichen eine gleichzeitige Uebertragung unterschiedlicher Informationen mit Hilfe nur eines Trägers und tragen somit zu einer ökonomischen Nutzung der Frequenzbänder bei.

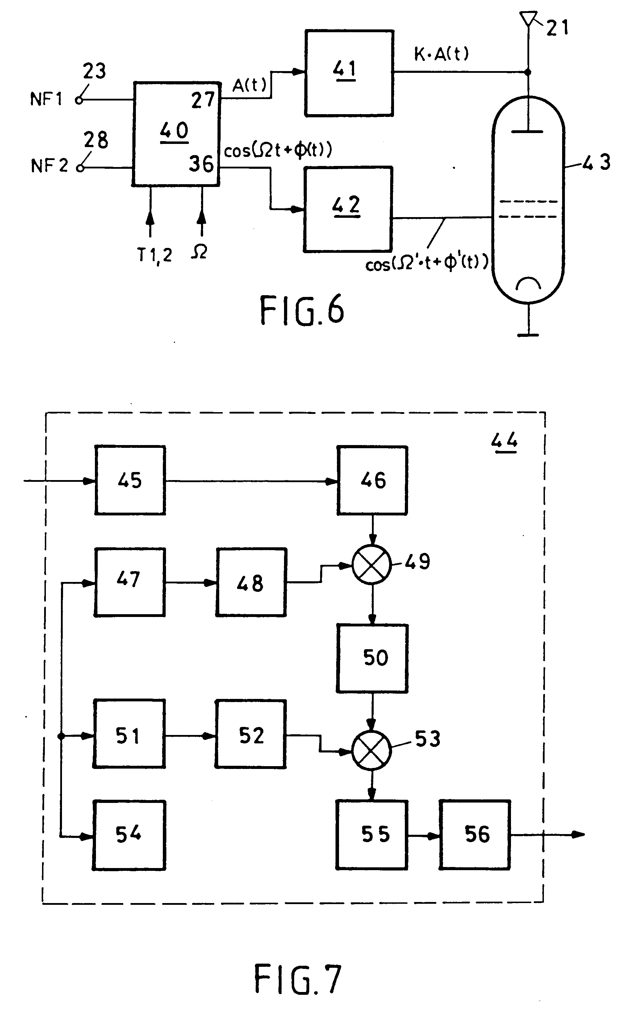

Bei dem aus der eingangs genannten Druckschrift bekannten ISB-Verfahren werden zur Erzeugung des Sendesignals die verschiedenen (oberen und unteren) Seitenbänder einzeln durch entsprechende Modulation und Filterung erzeugt, anschliessend addiert und auf die endgültige Trägerfrequenz umgesetzt (siehe Fig.6-8).

Das auf diese Weise entstehende Sendesignal wird schliesslich mit Hilfe linearer HF-Verstärker auf die Sendeleistung verstärkt und in eine Antenne eingespeist.

Nachteilig ist bei diesem Verfahren, dass die lineare HF-Leistungsverstärkung in der Senderendstufe hohe Anforderungen an die Schaltungstechnik stellt und vor allem zu ungünstigen Wirkungsgraden führt.

Aehnliche Probleme treten auch bei den mit linearer Verstärkung arbeitenden SSB-Verfahren auf. Man hat daher auf diesem Gebiet vorgeschlagen (EP-A1 0 193 655), das SSB-Signal nicht im Kleinsignalbereich zu erzeugen und anschliessend linear zu verstärken, sondern direkt an der einzigen Senderöhre in der Sender-Endstufe durch eine kombinierte Amplituden- und Phasenmodulation zu bilden.

Zu diesem Zweck wird aus dem niederfrequenten Eingangssignal ein Amplitudensignal und ein Phasensignal erzeugt, welche die Amplituden- bzw. Phaseninformation des zu bildenden SSB-Signals enthalten.

Das Amplitudensignal kann dann effizient mittels eines Schaltverstärkers verstärkt und auf die Anode der Senderöhre gegeben werden, während das Phasensignal nach einer Frequenzumsetzung an einem Steuergitter der Senderöhre anliegt.

Das Amplitudensignal entsteht aus den durch eine Hilberttransformation gewonnenen orthogonalen Komponenten des Eingangssignals in einem nachgeschalteten Amplitudenrechner.

Das Phasensignal entsteht bei dem bekannten Verfahren aus diesen orthogonalen Komponenten durch eine geeignete zyklische Abtastung und nachfolgende Verarbeitung in einem Quotientenrechner.

### Darstellung der Erfindung

Aufgabe der vorliegenden Erfindung ist es nun, ein ISB-Verfahren zu schaffen, welches die gleichen Vorteile aufweist wie das zuvor beschriebene SSB-Verfahren, sowie eine entsprechende Vorrichtung zur Durchführung des Verfahrens anzugeben.

Die Aufgabe wird bei einem Verfahren der eingangs genannten Art dadurch gelöst, dass

(a) die NF-Signale in ihre orthogonalen Signalkomponenten zerlegt werden;

(b) aus den gleichphasigen Signalkomponenten beider NF-Signale und einer Trägeramplitude jeweils eine Komponentensumme X bzw. Y gebildet wird, wobei in einer der Komponentensummen eine Signalkomponente mit umgekehrtem Vorzeichen addiert wird;

(c) aus den Komponentensummen ein Amplitudensignal A(t) nach Massgabe der Formel

$$A(t) = \sqrt{(X^2 + Y^2)}$$

berechnet wird;

(d) die Komponentensummen jeweils invertiert werden;

(e) die Komponentensummen und ihre Inversen in der Reihenfolge X,Y,-X,-Y oder X,-Y,-X,Y mit einer Zwischenträgerfrequenz zyklisch abgetastet werden;

(f) aus dem Abtastsignal ein Phasensignal gewonnen wird; und

(g) das Amplitudensignal und das Phasensignal jeweils zur Anodenmodulation bzw. Gittermodulation einer Senderöhre verwendet werden.

Das Verfahren hat den Vorteil, dass hier die einzelnen Seitenbänder nicht auf Kleinsignalniveau erzeugt und anschliessend linear auf hohe Leistung verstärkt werden müssen, sondern das Sendesignal direkt an der Senderöhre aus einem Amplitudensignal und einem Phasensignal gebildet wird, wobei das Amplitudensignal in einfacher Weise mittels eines Schaltverstärkers auf das Sendeleistungsniveau verstärkt werden kann.

Die erfindungsgemässe Vorrichtung umfasst

(a) erste Mittel zur Zerlegung der NF-Signale in ihre orthogonalen Signalkomponenten;

(b) zwei Addierer, welche mit ihren Eingängen an die Ausgänge der ersten Mittel angeschlossen sind derart, dass sie jeweils aus den gleichphasigen Signalkomponenten und einer Trägeramplitude die entsprechenden Komponentensummen bilden;

(c) einen ersten Invertierer, welcher vor einem Eingang eines der Addierer angeordnet ist und das Vorzeichen einer der Signalkomponenten vertauscht;

(d) einen Amplitudenrechner, dessen Eingänge mit den Ausgängen der Addierer verbunden sind und dessen Ausgang mit einem Amplitudenausgang in Verbindung steht;

(e) zwei weitere Invertierer, deren Eingänge jeweils mit den Ausgängen der Addierer verbunden sind und das Vorzeichen der Komponentensummen vertauschen;

(f) einen zyklischen Abtaster mit vier Eingängen, die jeweils mit den Ausgängen der Addierer und den Ausgängen der weiteren Invertierer in Verbindung stehen, derart, dass bei der zyklischen Abtastung die Komponentensummen und ihre Inversen in der Reihenfolge X,Y,-X,-Y oder X,-Y,-X,Y abgetastet werden;

(g) zweite Mittel zur Erzeugung eines Phasensignals, welche eingangsseitig mit dem Ausgang des zyklischen Abtasters und ausgangsseitig mit einem Phasenausgang in Verbindung stehen;

(h) eine Senderöhre mit einer Anode und einem Steuergitter; und

(i) dritte Mittel zur Aufbereitung des Amplitudensignals und des Phasensignals, welche zwischen der Senderöhre und dem Amplitudenausgang und dem Phasenausgang angeordnet sind.

In einem ersten bevorzugten Ausführungsbeispiel des erfindungsgemässen Verfahrens wird die Zerlegung der NF-Signale in ihre orthogonalen Signalkomponenten mittels einer Hilberttransformation durchgeführt.

In einem zweiten bevorzugten Ausführungsbeispiel wird das Amplitudensignal zunächst in einem Schaltverstärker verstärkt und das verstärkte Amplitudensignal zur Anodenmodulation der Senderöhre verwendet.

Weitere Ausführungsbeispiele ergeben sich aus den Unteransprüchen.

Kurze Beschreibung der Zeichnung

Die Erfindung soll nachfolgend anhand von Ausführungsbeispielen im Zusammenhang mit der Zeichnung näher erläutert werden. Es zeigen

Fig.1 im Blockschaltbild den Aufbau eines ISB-Senders nach dem Stand der Technik;

Fig.2A,B zwei unabhängige NF-Signale in der Zeigerdarstellung mit ihren orthogonalen Signalkomponenten;

Fig.3A die Zusammensetzung des zugehörigen ISB-Signals mit einem ersten Träger in der Zeigerdarstellung;

Fig.3B das entsprechende ISB-Signal mit einem zweiten Träger;

Fig.4 die durch zyklische Abtastung erzeugte Rotation des ISB-Zeigers;

Fig.5 das Blockschaltbild eines ISB-Modulators gemäss einem bevorzugten Ausführungsbeispiel der Erfindung mit zwei Varianten für die Signalverarbeitung hinter dem zyklischen Abtaster 34;

Fig.6 das Prinzipschaltbild eines entsprechenden Senders; und

Fig.7 den inneren Aufbau eines Analogteils 44 aus der Schaltung gemäss Fig.5.

Wege zur Ausführung der Erfindung

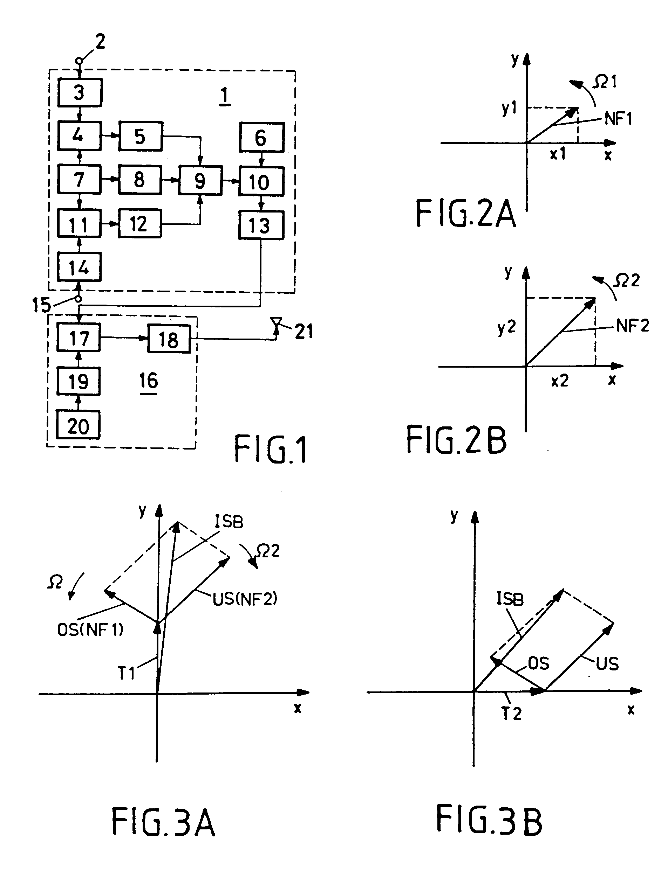

In Fig.1 ist im Blockschaltbild ein ISB-Sender nach dem Stand der Technik dargestellt. Er setzt sich zusammen aus einem ISB-Modulator 1 und dem eigentlichen Sender 16.

Der ISB-Modulator 1 besitzt zwei NF-Eingänge 2 und 15, an denen die zwei unabhängigen, zu übertragenden NF-Signale anstehen. Die NF-Signale gelangen von den NF-Eingängen 2,15 über entsprechende NF-Verstärker 3,14 auf Modulatoren 4,11, wo sie auf einen ersten, aus einem Oszillator 7 stammenden Träger aufmoduliert werden.

Die zwei dabei entstehenden Zweiseitenbandsignale werden in geeigneten Seitenband-Filtern 5,12 von dem jeweils unerwünschten einen Seitenband befreit und anschliessend einem Addierer 9 zugeführt, wo sie zu dem in einem Abschwächer 8 reduzierten ersten Träger addiert werden.

Das resultierende Summensignal wird in einem Mischer 10 auf eine aus einem weiteren Oszillator 6 stammende Frequenz umgesetzt, anschliessend in einem Verstärker 13 zwischenverstärkt und schliesslich in einem weiteren Mischer 17 in ein Frequenzband umgesetzt, das von einem Sythesizer 20 mit nachfolgendem Vervielfacher 19 bestimmt wird.

Die endgültige Verstärkung des Sendesignals übernimmt eine Leistungsstufe 18, deren Ausgang mit einer Antenne 21 in Verbindung steht.

Das bekannte ISB-Verfahren zeichnet sich daher durch folgende charakteristische Merkmale aus:

-- die unabhängigen Seitenbänder werden direkt auf Kleinsignalniveau erzeugt und durch Addition zu einem Sendesignal zusammengesetzt; und

-- die Leistungsverstärkung in der Senderendstufe erfolgt mittels eines linearen HF-Verstärkers, da das Sendesignal als Ganzes verstärkt werden muss.

Die vorliegende Erfindung geht hier einen vollkommen anderen Weg,der mit Hilfe der Vektordarstellungen der beteiligten Signale in den Fig.2a-4 erläutert werden soll:

Ausgangspunkt sind zwei unabhängige NF-Signale NF1,2, die in einer x-y-Ebene als rotierende Vektoren mit den jeweiligen Signalkomponenten $x1,y1$ und $x2,y2$ dargestellt werden können. Das erste NF-Signal NF1 hat die Kreisfrequenz $\Omega 1$, das zweite entsprechend die Kreisfrequenz $\Omega 2$ (Fig.2A,B).

Werden nun die NF-Signale NF1 und NF2 zu einem konstanten, nicht rotierenden Träger T1 vektoriell addiert, wobei die Rotation der NF-Signale NF1,2 gegensinnig gewählt wird, erhält man den in Fig.3A gezeigten Vektor ISB, der zwar noch nicht mit einer Trägerfrequenz rotiert, aber die vollständige Amplitudeninformation eines ISB-Signals enthält.

Für die vektorielle Addition werden die NF-Signale NF1,2 zuächst in ihre orthogonalen Signalkomponenten $x1,y1$ bzw. $x2,y2$ zerlegt und die gleichphasigen Signalkomponenten $x1,2$ bzw. $y1,2$ addiert. Die gegensinnige Rotation wird dadurch erreicht, dass in einem Komponentenpaar die eine Signalkomponente ($x1$ in Fig.3A) mit negativem Vorzeichen addiert wird. Man erhält auf diese Weise aus dem einen NF-Signal (NF1) ein oberes Seitenband OS und aus dem anderen NF-Signal (NF2) ein unteres Seitenband US.

Im Fall der Fig.3A ist der Einfachheit halber eine Trägeramplitude T1 mit verschwindender x-Komponente gewählt worden. Genausogut kann jedoch auch eine Trägeramplitude T2 mit verschwindender y-Komponente genommen werden (Fig.3B) oder eine Trägeramplitude mit beliebigen x- und y-Komponenten.

Um nun ein vollständiges Sendesignal zu erhalten, muss der Vektor ISB zusätzlich in er x-y-Ebene in eine konstante Rotation mit einer Kreisfrequenz versetzt werden, die der Trägerfrequenz entspricht. Zu diesem Zweck werden die Komponenten des Vektors ISB zyklisch in einer vorgegebenen Reihenfolge abgetastet.

Die Komponenten des Vektors ISB sind Komponentensummen X und Y, die sich im Hinblick auf die Fig.3A und B wie folgt ergeben:

Fig.3A:

$$X = x2 - x1$$
$$Y = y1 + y2 + T1$$

Fig.3B:

$$X = x2 - x1 + T2$$
$$Y = y1 + y2$$

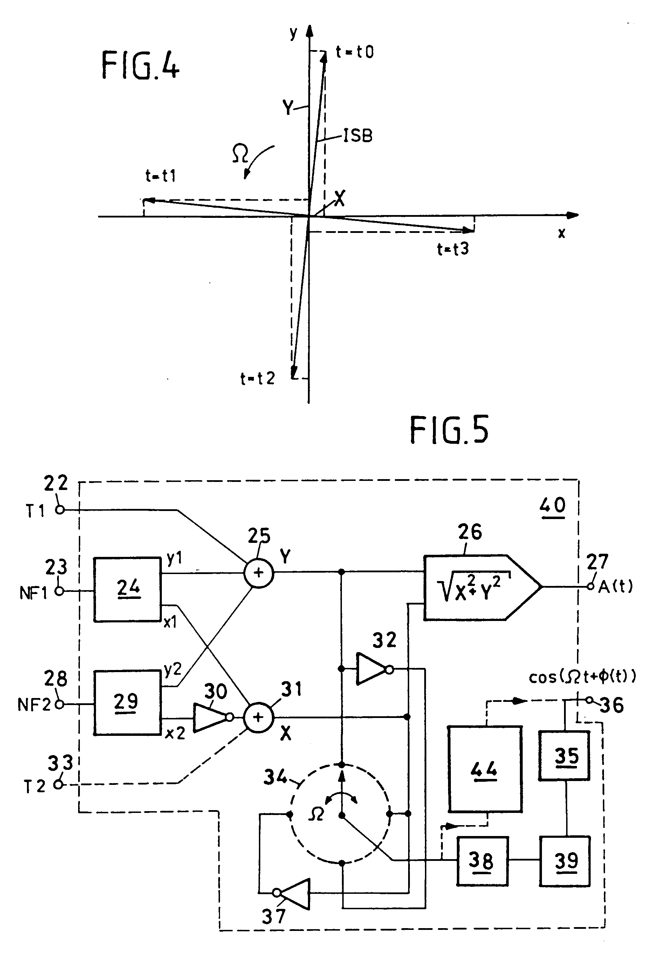

Wie aus der Fig.4 leicht ersichtlich ist, kann eine Rotation des Vektors ISB durch eine geeignete Vertauschung der Komponenten X und Y mit entsprechendem Vorzeichenwechsel nachgebildet werden.

Wenn z.B. der Vektor zum Zeitpunkt $t = t0$ dieselbe Lage in der Ebene einnimmt wie in Fig.3A und zu diesem Zeitpunkt die Komponenten X und Y hat, ergibt eine Rotation um 90 Grad entgegen dem Uhrzeigersinn zum späteren Zeitpunkt $t = t1$ einen Vektor mit den Komponenten -Y,X. Bei einer weiteren Rotation um 90 Grad ($t = t2$) hat der Vektor die Komponenten -X,-Y, bei nochmaliger Rotation um 90 Grad ($t = t3$) die Komponenten Y,-X.

Daraus folgt, dass ein mit einer Zwischenträgerfrequenz $\Omega$ rotierender Vektor ISB dadurch nachgebildet werden kann, dass in einem mit $\Omega$ rotierenden zyklischen Abtaster die Komponenten X und Y in der zyklischen Reihenfolge X,-Y,-X,Y,X,-Y,... abgetastet werden.

Die genannte Reihenfolge gilt dabei für eine Rotation entgegen dem Uhrzeigersinn. Für eine Rotation mit dem Uhrzeigersinn lautet die entsprechende Reihenfolge X,Y,-X,-Y,X,Y,...

Da der Vektor ISB unter anderem aus den rotierenden und sich in der Länge ändernden Vektoren der NF-Signale NF1 und NF2 zusammengesetzt ist, ändert er selbst in entsprechendem Masse Richtung und Länge und damit auch die Phase.

Während die Länge auf einfache Weise aus den Komponentensummen X und Y berechnet werden kann und damit ein Amplitudensignal A(t) zur Verfügung steht, muss die im ISB-Signal enthaltene Phaseninformation in besonderer Weise gewonnen werden.

Ziel dabei ist es, ein harmonisches Phasensignal der Form $\cos(\Omega^{*}t + \Phi(t))$ zu erhalten, welches die für die Erzeugung des ISB-Signals notwendige Phaseninformation $\Phi(t)$ enthält.

Falls die Zwischenträgerfrequenz $\Omega$ viel grösser als die Grenzfrequenzen der NF-Signale NF1 und NF2 ist, sind die Nulldurchgänge der o.g. cos-Funktion fast gleich den Nulldurchgängen der Folgen von Abtastwerten, die beim erwähnten zyklischen Abtasten der Komponenten X und Y entstehen.

Zunächst werden deshalb die Nulldurchgänge bestimmt. Aus diesen Nulldurchgängen wird dann ein Rechtecksignal erzeugt, welches anschliessend durch eine Bandpass-Filterung in die gewünschte cos-Funktion umgewandelt wird.

Das Phasensignal kann dann von der Zwischenträgerfrequenz $\Omega$ auf die erforderliche Trägerfrequenz $\Omega'$ umgesetzt und zur Phasenmodulation im Sender verwendet werden. Das Produkt

$$A(t)^*\cos(\Omega^*t + \Phi(t))$$

aus dem Amplitudensignal A(t) und dem Phasensignal ist schliesslich das gewünschte ISB-Signal.

Diese erfindungsgemässe Art der Signalaufbereitung hat die folgenden Vorteile:

-- Amplituden- und Phasensignal werden bis zur Sender-Endstufe getrennt verarbeitet; und

-- da das Amplitudensignal ein niederfrequentes Signal mit Gleichspannungsanteil ist, kann für die notwendige Leistungsverstärkung ein niederfrequenter Schaltverstärker einumgesetzt werden, der einen besonders guten Wirkungsgrad erreicht.

Eine bevorzugte Ausführungsform eines ISB-Modulators nach der Erfindung ist in Fig.5 im Blockschaltbild wiedergegeben.

Der ISB-Modulator 40 hat zwei NF-Eingänge 23,28 und wenigstens einen Trägeramplituden-Eingang 22 bzw. 33., sowie zwei Ausgänge, von denen der eine ein Amplitudenausgang 27 und der andere ein Phasenausgang 36 ist.

Die beiden unabhängigen NF-Signale NF1 und NF2 gelangen über die jeweiligen NF-Eingänge 23,28 auf die Eingänge zweier Hilbert-Transformatoren 24,29 und werden dort in ihre orthogonalen Signalkomponenten x1,y1 bzw. x2,y2 zerlegt, die an entsprechenden Ausgängen anstehen.

Den Hilbert-Transformatoren 24,29 sind Addierer 25,31 nachgeschaltet, in denen die Komponentensummen X und Y gebildet werden. Zu den orthogonalen Signalkomponenten wird in wenigstens einem der Addierer zusätzlich die bereits erwähnte Trägerampliude addiert. Hat diese Trägeramplitude nur eine y-Komponente (T1), erfolgt die Addition in dem für die Komponentensumme Y zuständigen Addierer 25 (in Fig.5 durchgezogen dargestellt). Hat diese Trägeramplitude dagegen nur eine x-Komponente (T2), wird sie im für die Komponentensumme X zuständigen Addierer 31 addiert (in Fig.5 gestrichelt dargestellt). Sind schliesslich beide Komponenten vorhanden, werden beide Addierer 25 und 31 benutzt.

Der für die Auftrennung in oberes und unteres Seitenband (OS bzw. US) notwendige Vorzeichenwechsel bei einer der Signalkomponenten wird durch einen ersten Invertierer 30 bewirkt, der zwischen dem Addierer 31 und dem x2-Ausgang des Hilbert-Transformators 29 angeordnet ist. Es versteht sich von selbst, dass bei einem möglichen Vorzeichenwechsel anderer Signalkomponenten der Invertierer 30 entsprechend anders angeordnet werden muss.

Die an den Ausgängen der Addierer anstehenden Komponentensummen X und Y werden zur Berechnung der Amplitude bzw. des Amplitudensignals A(t) in einen Amplitudenrechner 26 gegeben, der die Komponentensummen jeweils quadriert, die Quadrate addiert und aus der resultierenden Summe die Quadratwurzel zieht, d.h.:

$$A(t) = \sqrt{(X2 + Y2)}$$

Dieses Amplitudensignal A(t) aus dem Amplitudenrechner 26 erscheint dann am Amplitudenausgang 27.

Die Komponentensummen X und Y werden weiterhin direkt und über zwei weitere Invertierer 32,37 mit geändertem Vorzeichen auf die vier Eingänge eines zyklischen Abtasters 34 gegeben, wobei die Eingänge entgegen dem Uhrzeigersinn in der Reihenfolge X,Y,-X,-Y belegt werden.

Der zyklische Abtaster 34 tastet die Komponentensummen je nach Drehsinn in dieser oder der umgekehrten Reihenfolge mit der Zwischenträgerfrequenz $\Omega$ ab und gibt (in einer ersten Variante der Schaltung) die Abtastwerte auf einen Nulldurchgangsdetektor 38, der die Nulldurchgänge bestimmt.

Anhand dieser Nulldurchgänge wird dann in einem nachfolgenden Rechteckumformer 39 eine Rechteckfunktion mit gleichartigen Nulldurchgängen erzeugt (der Rechteckumformer 39 kann auch weggelassen werden, wenn der Nulldurchgangsdetektor 38 an seinem Ausgang direkt eine entsprechende Rechteckfunktion abgibt). Aus der erzeugten Rechteckfunktion wird in einem nachgeschalteten Bandpassfilter 35 mit der Mittenfrequenz $2pi^*\Omega$ das harmonische Phasensignal

$$\cos(\Omega^*t + \Phi(t))$$

herausgefiltert und an den Phasenausgang 36 weitergeleitet.

In einer zweiten Variante der Schaltung ist anstelle von Nulldurchgangsdetektor 38, Rechteckumformer 39 und Bandpassfilter 35 zwischen dem Phasenausgang 36 und dem zyklischen Abtaster 34 ein Analogteil 44 angeordnet, der später im Zusammenhang mit der Fig.7 detailliert beschrieben werden soll.

Auf die tatsächliche Ausführung von Hilbert-Transformatoren 24,29, zyklischem Abtaster 34 und Amplitudenrechner 26 soll hier nicht näher eingegangen werden, da mögliche Ausführungsbeispiele dieser Funktionsblöcke bereits aus der eingangs genannten EP-A1 0 193 655 bekannt sind.

Die im ISB-Modulator 40 erzeugten Signale Amplitudensignal A(t) und Phasensignal cos(...) werden schliesslich gemäss Fig.6 getrennt weiterverarbeitet und in einer Senderöhre 43 auf hohem Leistungsniveau zum endgültigen ISB-Signal zusammengesetzt.

Die Weiterverarbeitung umfasst dabei die Leistungsverstärkung des Amplitudensignals A(t) in einem Schaltverstärker 41 (um einen Verstärkungsfaktor k) und die Umsetzung des Phasensignals von der Zwischenträgerfrequenz $\Omega$ auf eine endgül-tige Trägerfrequenz $\Omega'$ in einem Frequenzumsetzer 42. Die ursprüngliche Phase $\Phi(t)$ wandelt sich da-bei in die endgültige Phase $\Phi'(t)$ um.

Das umgesetzte Phasensignal wird einem Steuergitter der Senderöhre 43 zugeführt, das verstärkte Amplitudensignal k*A(t) gelangt auf die Anode der Senderöhre.

Als Schaltverstärker wird vorzugsweise ein sogenannter PSM(Puls-Stufen-Modulator)-Verstärker verwendet, wie er aus der Druckschrift Brown Boveri Mitt. 5 (1984), S.202-205, bekannt ist.

Wie bereits vorher erwähnt, kann in einer Variante der Schaltung nach Fig.5 für die Signalverarbeitung hinter dem zyklischen Abtaster 34 ein Analogteil 44 vorgesehen werden, dessen innerer Aufbau beispielhaft in Fig.7 dargestellt ist.

Die Zwischenträgerfrequenz $\Omega$ beträgt bei die-ser Variante z.B. 25 kHz, die Abtastung im zyklischen Abtaster 34 erfolgt dementsprechend mit der vierfachen Frequenz, d.h. mit 100 kHz. Das digitale Abtastsignal aus dem zyklischen Abtaster 34 wird im Analogteil 44 zunächst einem D/A-Wandler 45 zugeführt und dort zu einem Analogsignal umgewandelt.

Das Analogsignal wird über ein Tiefpassfilter 46, welches mit einer oberen Grenzfrequenz von 37 kHz die vorhandenen Spiegelspektren wegfiltert, auf einen ersten Mischer 49 gegeben und dort mit einer Frequenz von 50 kHz auf 75 kHz gemischt.

Nach der Filterung in einem 75 kHz-Bandpassfilter 50 wird das Analogsignal in einem zweiten Mischer 53 mit 125 kHz auf 200 kHz gemischt. Nach einer weiteren Filterung in einem 200 kHz-Bandpassfilter 55 wird das Analogsignal schliesslich einem schnellen Komparator 56 zugeführt, der das Signal klippt und auf diese Weise auf seine Phaseninformation reduziert. Das geklippte Signal kann dann als Phasensignal direkt (wie die cos-Funktion in der anderen Variante) im Sender weiterverarbeitet werden.

Die Mischfrequenzen von 50 kHz und 125 kHz werden aus einem gemeinsamen 1 MHz-Oszillator 54 durch entsprechende Teilung in den Frequenzteilern 47 (Teilung durch 20) und 51 (Teilung durch 8) mit nachfolgender Filterung in den Bandpassfiltern 48 und 52 erzeugt. Die Schaltungsblöcke 47 bis 55 bilden insgesamt einen Aufwärtsmischer.

Die eben beschriebene Variante, bei der die Phaseninformation durch das Klippen erst nach dem Aufwärtsmischen extrahiert wird, hat den besonderen Vorteil, dass der Einfluss der begrenzten Bandbreite in den Signalverarbeitungspfaden auf die Phaseninformation besonders gering ist.

Insgesamt ergibt sich mit der Erfindung ein ISB-Sender, der sich vereinfacht aufbauen lässt und sich durch einen hohen Wirkungsgrad auszeichnet.

## Patentansprüche

1. Verfahren zur Erzeugung eines amplitudenmodulierten ISB-Sendesignals mit einem oberen Seitenband (OS) und einem unteren Seitenband (US), welche Seitenbänder (OS,US) von-einander unabhängig unterschiedliche Informa-tionen in Form von unterschiedlichen NF-Signalen (NF1,2) übertragen, dadurch gekennzeichnet, dass

   (a) die NF-Signale (NF1,2) in ihre orthogonalen Signalkomponenten (x1,y1 bzw. x2,y2) zerlegt werden;
   (b) aus den gleichphasigen Signalkomponenten (x1,2 bzw. y1,2) beider NF-Signale (NF1,2) und einer Trägeramplitude (T1,2) jeweils eine Komponentensumme X bzw. Y gebildet wird, wobei in einer der Komponentensummen (X,Y) eine Signalkomponente mit umgekehrtem Vorzeichen addiert wird;
   (c) aus den Komponentensummen (X,Y) ein Amplitudensignal A(t) nach Massgabe der Formel

   $$A(t) = \sqrt{(X^2 + Y^2)}$$

   berechnet wird;
   (d) die Komponentensummen (X,Y) jeweils invertiert werden;
   (e) die Komponentensummen (X,Y) und ihre Inversen (-X,-Y) in der Reihenfolge X,Y,-X,-Y oder X,-Y,-X,Y mit einer Zwischenträgerfre-quenz ($\Omega$) zyklisch abgetastet werden;
   (f) aus dem Abtastsignal ein Phasensignal gewonnen wird; und
   (g) das Amplitudensignal (A(t)) und das Phasensignal jeweils zur Anodenmodulation bzw. Gittermodulation einer Senderöhre (43) verwendet werden.

2. Verfahren nach Anspruch 1, dadurch gekennzeichnet, dass zur Gewinnung des Phasensignals

(a) die Nulldurchgänge des Abtastsignals detektiert werden; und

(b) aus den Nulldurchgängen des Abtastsignals ein Rechtecksignal erzeugt und anschliessend einer Bandpass-Filterung unterzogen wird; sodass

(c) ein harmonisches Phasensignal (cos(Ω•t + Φ(t))) mit der Zwischenträgerfrequenz (Ω) und einer ersten Phase (Φ(t)) entsteht, welches Phasensignal dieselben Nulldurchgänge aufweist wie das Abtastsignal;

3. Verfahren nach Anspruch 1, dadurch gekennzeichnet, dass zur Gewinnung des Phasensignals

(a) das Abtastsignal in ein Analogsignal umgewandelt wird;

(b) das Analogsignal auf eine höhere Frequenz hochgemischt wird; und

(c) das hochgemischte Analogsignal geklippt wird.

4. Verfahren nach Anspruch 1, dadurch gekennzeichnet, dass die Zerlegung der NF-Signale (NF1,2) in ihre orthogonalen Signalkomponenten (x1,y1 bzw. x2,y2) mittels einer Hilberttransformation durchgeführt wird;

5. Verfahren nach Anspruch 1, dadurch gekennzeichnet, dass das Phasensignal zunächst auf eine Trägerfrequenz (Ω′), welche höher ist als die Zwischenträgerfrequenz (Ω), umgesetzt und das umgesetzte Phasensignal zur Gittermodulation der Senderöhre (43) verwendet wird.

6. Verfahren nach Anspruch 1, dadurch gekennzeichnet, dass das Amplitudensignal (A(t)) zunächst in einem Schaltverstärker (41) verstärkt und das verstärkte Amplitudensignal zur Anodenmodulation der Senderöhre (43) verwendet wird.

7. Verfahren nach Anspruch 2, dadurch gekennzeichnet, dass eine Zwischenträgerfrequenz (Ω) verwendet wird, die sehr viel grösser ist, als die obere Grenzfrequenz der NF-Signale (NF1,2).

8. Vorrichtung zur Durchführung des Verfahrens nach Anspruch 1, gekennzeichnet durch

(a) erste Mittel zur Zerlegung der NF-Signale (NF1,2) in ihre orthogonalen Signalkomponenten (x1,y1 bzw.x2,y2);

(b) zwei Addierer (25,31), welche mit ihren Eingängen an die Ausgänge der ersten Mittel angeschlossen sind derart, dass sie jeweils aus den gleichphasigen Signalkomponenten (x1,x2 bzw.y1,y2) und einer Trägeramplitude (T1,2) die entsprechenden Komponentensummen (X bzw.Y) bilden;

(c) einen ersten Invertierer (30), welcher vor einem Eingang eines der Addierer (25,31) angeordnet ist und das Vorzeichen einer der Signalkomponenten (x1,2 bzw.y1,2) vertauscht;

(d) einen Amplitudenrechner (26), dessen Eingänge mit den Ausgängen der Addierer (25,31) verbunden sind und dessen Ausgang mit einem Amplitudenausgang (27) in Verbindung steht;

(e) zwei weitere Invertierer (32,37), deren Eingänge jeweils mit den Ausgängen der Addierer (25,31) verbunden sind und das Vorzeichen der Komponentensummen (X,Y) vertauschen;

(f) einen zyklischen Abtaster (34) mit vier Eingängen, die jeweils mit den Ausgängen der Addierer (25,31) und den Ausgängen der weiteren Invertierer (32,37) in Verbindung stehen, derart, dass bei der zyklischen Abtastung die Komponentensummen (X,Y) und ihre Inversen (-X,-Y) in der Reihenfolge X,Y,-X,-Y oder X,-Y,-X,Y abgetastet werden;

(g) zweite Mittel zur Erzeugung eines Phasensignals, welche eingangsseitig mit dem Ausgang des zyklischen Abtasters (34) und ausgangsseitig mit einem Phasenausgang (36) in Verbindung stehen;

(h) eine Senderöhre (43) mit einer Anode und einem Steuergitter; und

(i) dritte Mittel zur Aufbereitung des Amplitudensignals (A(t)) und des Phasensignals, welche zwischen der Senderöhre (43) und dem Amplitudenausgang (27) und dem Phasenausgang (36) angeordnet sind.

9. Vorrichtung nach Anspruch 8, dadurch gekennzeichnet, dass die ersten Mittel zwei Hilbert-Transformatoren (24,29) umfassen.

10. Vorrichtung nach Anspruch 9, dadurch gekennzeichnet, dass die zweiten Mittel einen Nulldurchgangsdetektor (38) und ein nachgeschaltetes Bandpassfilter (35) umfassen.

11. Vorrichtung nach Anspruch 9, dadurch gekennzeichnet, dass die zweiten Mittel einen Analogteil (44) mit einem eingangsseitigen D/A-Wandler (45), einem Aufwärtsmischer (47,...,55) und einem nachgeschalteten Komparator (56) umfassen.

12. Vorrichtung nach Anspruch 9, dadurch gekennzeichnet, dass die dritten Mittel einen Schaltverstärker (41) und einen Frequenzumsetzer (42) umfassen, wobei der Schaltverstärker (41) zwischen dem Amplitudenausgang (27) und der Anode der Senderöhre (43) und der Frequenzumsetzer (42) zwischen dem Phasenausgang (36) und dem Steuergitter der Senderöhre (43) angeordnet ist.

## Claims

1. Method of generating an amplitude-modulated ISB transmission signal with an upper side band (OS) and a lower side band (US), which side bands (OS, US) transmit independently of each other different information in the form of different AF signals (NF1,2), characterized in that

   (a) the AF signals (NF1,2) are split into their orthogonal signal components (x1, y1 and x2, y2, respectively);

   (b) from the in-phase signal components (x1,2 and y1,2, respectively) of the two AF signals (NF1,2) and of a carrier amplitude (T1,2), in each case a component sum X and Y is formed, a signal component with inverse operational sign being added in one of the component sums (X,Y);

   (c) from the component sums (X,Y), an amplitude signal A(t) is calculated according to the formula

   $$A(t) = \sqrt{(X^2 + Y^2)};$$

   (d) the component sums (X,Y) are in each case inverted;

   (e) the component sums (X,Y) and their inverses (-X,-Y) are cyclically scanned with a subcarrier frequency ($\Omega$) in the order X,Y,-X,-Y or X,-Y,-X,Y;

   (f) a phase signal is obtained from the scanning signal; and

   (g) the amplitude signal (A(t)) and the phase signal are in each case used for the anode modulation and grid modulation of a transmitting tube (43).

2. Method according to Claim 1, characterized in that, for the obtainment of the phase signal,

   (a) the zero transitions of the scanning signal are detected; and

   (b) a square-wave signal is generated from the zero transitions of the scanning signal and subsequently subjected to a bandpass filtering; so that

   (c) a harmonic phase signal (cos($\Omega$ t + $\phi$(t))) with the subcarrier frequency ($\Omega$) and a first phase ($\phi$(t)) is produced, which phase signal has the same zero transitions as the scanning signal;

3. Method according to Claim 1, characterized in that, for the obtainment of the phase signal,

   (a) the scanning signal is converted into an analog signal;

   (b) the analog signal is converted up to a higher frequency; and

   (c) the up-converted analog signal is clipped.

4. Method according to Claim 1, characterized in that the splitting of the AF signals (NF1,2) into their orthogonal signal components (x1, y1 and x2, y2, respectively) is carried out by means of a Hilbert transformation;

5. Method according to Claim 1, characterized in that the phase signal is firstly converted to a carrier frequency ($\Omega'$) which is higher than the subcarrier frequency ($\Omega$) and the converted phase signal is used for the grid modulation of the transmitting tube (43).

6. Method according to Claim 1, characterized in that the amplitude signal (A(t)) is firstly amplified in a switching amplifier (41) and the amplified amplitude signal is used for the anode modulation of the transmitting tube (43).

7. Method according to Claim 2, characterized in that a sub-carrier frequency ($\Omega$) is used which is very much greater than the upper cut-off frequency of the AF signals (NF1,2).

8. Apparatus for carrying out the method according to Claim 1, characterized by

   (a) first means for the splitting of the AF signals (NF1,2) into their orthogonal signal components (x1,y1 and x2,y2, respectively);

   (b) two adders (25, 31), which are connected via their inputs to the outputs of the first means in such a way that they in each case form the corresponding component sums (X and Y) from the in-phase signal components (x1,x2 and y1,y2, respectively) and a carrier amplitude (T1,T2);

   (c) a first inverter (30), which is arranged ahead of an input of one of the adders (25, 31) and exchanges the operational sign of one of the signal components (x1,2 or y1,2);

   (d) an amplitude computer (26), the inputs of which are connected to the outputs of the adders (25, 31) and the output of which is in connection with an amplitude output (27);

   (e) two further inverters (32, 37), the inputs of which are in each case connected to the outputs of the adders (25, 31) and exchange the operational sign of the component sums (X,Y);

(f) a cyclic scanner (34) with four inputs, which are in each case in connection with the outputs of the adders (25, 31) and the outputs of the further inverters (32, 37) in such a way that, in the cyclic scanning, the component sums (X,Y) and their inverses (-X,-Y) are scanned in the order X,Y,-X,-Y or X,-Y,-X,Y;

(g) second means for the generation of a phase signal, which are in connection on the input side with the output of the cyclic scanner (34) and on the output side with a phase output (36);

(h) a transmitting tube (43) with an anode and a control grid; and

(i) third means for the conditioning of the amplitude signal (A(t)) and of the phase signal, which are arranged between the transmitting tube (43) and the amplitude output (27) and the phase output (36).

9. Apparatus according to Claim 8, characterized in that the first means comprise two Hilbert transformers (24, 29).

10. Apparatus according to Claim 9, characterized in that the second means comprise a zero transition detector (38) and a downstream bandpass filter (35).

11. Apparatus according to Claim 9, characterized in that the second means comprise an analog part (44) with a D/A converter (45) on the input side, an up-converter (47,...,55) and a downstream comparator (56).

12. Apparatus according to Claim 9, characterized in that the third means comprise a switching amplifier (41) and a frequency converter (42), the switching amplifier (41) being arranged between the amplitude output (27) and the anode of the transmitting tube (43) and the frequency converter (42) being arranged between the phase output (36) and the control grid of the transmitting tube (43).

**Revendications**

1. Procédé de production d'un signal d'émission ISB modulé en amplitude présentant une bande latérale supérieure (OS) et une bande latérale inférieure (US), ces bandes latérales (OS, US) transmettant, indépendamment l'une de l'autre, des informations différentes sous forme de signaux basse fréquence différents (NF1, 2), caractérisé en ce que :

(a) les signaux basse fréquence (NF1, 2) sont décomposés en leurs composantes de signal orthogonales (x1, y1 ou x2, y2);

(b) à partir des composantes de signal de même phase (x1, x2 ou y1, y2) des deux signaux basse fréquence (NF1, 2) et d'une amplitude de porteuse (T1, 2) est chaque fois formée une somme de composantes X ou Y, une composante de signal à signe inversé étant additionnée dans l'une des sommes de composantes (X, Y);

(c) à partir des sommes de composantes (X, Y), un signal d'amplitude A(t) est calculé suivant la formule

$$A(t) = \sqrt{(X2 + Y2)}$$

d) les sommes de composantes (X, Y) sont à chaque fois inversées;

(e) les sommes de composantes (X, Y) et leurs inverses (-x, -y) sont échantillonnés cycliquement dans l'ordre X, Y, -X, -Y ou X, -Y, -X, Y à une fréquence de porteuse intermédiaire ($\Omega$);

(f) à partir du signal d'échantillonnage est formé un signal de phase, et

(g) le signal d'amplitude (A(t)) et le signal de phase sont chaque fois utilisés pour une modulation par anode ou une modulation par grille d'un tube émetteur (43).

2. Procédé suivant la revendication 1, caractérisé en ce qu'en vue de l'obtention du signal de phase,

(a) les passages par zéro du signal d'échantillonnage sont détectés et,

(b) à partir des passages par zéro du signal d'échantillonnage est produit un signal rectangulaire qui est ensuite soumis à un filtrage passe-bas, de sorte que

(c) il se produit un signal de phase harmonique ($\cos(\Omega^* t + \Phi(t))$) à la fréquence de porteuse intermédiaire ($\Omega$) et une première phase ($\Phi(t)$), lequel signal de phase présente les mêmes passages par zéro que le signal d'échantillonnage.

3. Procédé suivant la revendication 1, caractérisé en ce qu'en vue de l'obtention du signal de phase :

(a) le signal d'échantillonnage est converti en un signal analogique;

(b) le signal analogique est mélangé vers le haut jusqu'à une fréquence supérieure, et

(c) le signal analogique mélangé vers le haut est écrêté.

**4.** Procédé suivant la revendication 1, caractérisé en ce que la décomposition des signaux basse fréquence (NF1, 2) en leurs composantes de signal orthogonales (x1, y1 ou x2, y2) est effectuée au moyen d'une transformation de Hilbert.

**5.** Procédé suivant la revendication 1, caractérisé en ce que le signal de phase est d'abord converti jusqu'à une fréquence de porteuse (Ω') qui est supérieure à la fréquence de porteuse intermédiaire (Ω) et le signal de phase converti est utilisé pour la modulation par grille du tube émetteur (43).

**6.** Procédé suivant la revendication 1, caractérisé en ce que le signal d'amplitude (A(t)) est d'abord amplifié dans un amplificateur de commutation (41) et le signal d'amplitude amplifié est utilisé pour la modulation par anode du tube émetteur (43).

**7.** Procédé suivant la revendication 2, caractérisé en ce qu'on utilise une fréquence de porteuse intermédiaire (Ω) qui est de beaucoup supérieure à la fréquence limite supérieure des signaux basse fréquence (NF1, 2).

**8.** Dispositif pour l'exécution du procédé suivant la revendication 1, caractérisé par

(a) des premiers moyens pour décomposer les signaux basse fréquence (NF1, 2) en leurs composantes de signal orthogonales (x1, y1 ou x2, y2);

(b) deux additionneurs (25, 31) qui sont connectés par leurs entrées aux sorties des premiers moyens de manière telle qu'ils forment chaque fois à partir des composantes de signal de même phase (x1, x2 ou y1, y2) et d'une amplitude de porteuse (T1, 2), les sommes de composantes correspondantes (X ou Y);

(c) un premier inverseur (30) qui est monté en amont d'une entrée de l'un des additionneurs (25, 31) et qui permet le signe de l'une des composantes de signal (x1, 2 ou y1, 2);

(d) un calculateur d'amplitude (26) dont les entrées sont connectées aux sorties des additionneurs (25, 31) et dont la sortie est connectée à une sortie d'amplitude (27);

(e) deux autres inverseurs (32, 37) dont les entrées sont connectées chaque fois aux sorties des additionneurs (25, 31) et qui permettent le signe des sommes de composantes (X, Y);

(f) un échantillonneur cyclique (34) à quatre entrées qui sont connectées chaque fois aux sorties des additionneurs (25, 31) et aux sorties des autres inverseurs (32, 37) de manière telle que lors de l'échantillonnage cyclique, les sommes de composantes (X, Y) et leurs inverses (-X, -Y) sont échantillonnés dans l'ordre X, Y, -X, -Y ou X, -Y, -X, Y;

(g) des seconds moyens pour produire un signal de phase qui sont connectés, du côté de l'entrée, à la sortie de l'échantillonneur cyclique (34) et du côté de la sortie, à une sortie de phase (36);

(h) un tube émetteur (43) comportant une anode et une grille de commande, et

(i) des troisièmes moyens pour préparer le signal d'amplitude (A(t)) et le signal de phase qui sont montés entre le tube émetteur (43) et la sortie d'amplitude (27) et la sortie de phase (36).

**9.** Dispositif suivant la revendication 8, caractérisé en ce que les premiers moyens comportent deux transformateurs de Hilbert (24, 29).

**10.** Dispositif suivant la revendication 9, caractérisé en ce que les seconds moyens comportant un détecteur de passage par zéro (38) et un filtre passe-bande (35) monté en aval.

**11.** Dispositif suivant la revendication 9, caractérisé en ce que les seconds moyens comportent une partie analogique (44) comprenant un convertisseur numérique-analogique (45) du côté de l'entrée, un mélangeur vers le haut (47, ..., 55) et un comparateur (56) monté en aval.

**12.** Dispositif suivant la revendication 9, caractérisé en ce que les troisièmes moyens comportant un amplificateur de commutation (41) et un convertisseur de fréquence (42), l'amplificateur de commutation (41) étant monté entre la sortie d'amplitude (27) et l'anode du tube émetteur (43) et le convertisseur de fréquence (42) étant monté entre la sortie de phase (36) et la grille de commande du tube émetteur (43).

FIG.1

FIG.2A

FIG.2B

FIG.3A

FIG.3B

# FIG.4

# FIG.5

FIG.6

FIG.7